# EUROPEAN PATENT SPECIFICATION

(11) **EP 2 290 699 B1**
(45) Date of publication and mention of the grant of the patent: **21.11.2018**
(21) Application number: 10010911.5
(22) Date of filing: 17.10.2007
(51) Int. Cl.: H01L 31/0224, H01L 31/072, H01L 21/302, H01L 21/461

(54) **Inverted metamorphic solar cell with via for backside contacts**
Umgekehrte metamorphe Solarzelle mit Bohrung für Rückseitenverbindungen
Cellule solaire métamorphique inversée dotée de voies pour des contacts en face arrière

(30) Priority: 02.02.2007 US 701741
(43) Date of publication of application: 02.03.2011
(62) Divisional of application: 07020333.6
(73) Proprietor: SolAero Technologies Corp., Albuquerque, NM 87123 (US)
(72) Inventor: Sharps, Paul R., Albuquerque, NM 87112 (US)
(74) Representative: adares Patent- und Rechtsanwälte Reininger & Partner GmbB

(56) References cited:
- JP-A- 63 211 773
- JP-A- 2004 095 669
- US-A1- 2004 166 681
- US-A1- 2006 144 435
- US-A1- 2006 231 130
- VAN KERSCHAVER E ET AL: "Back-contact solar cells: a review", PROGRESS IN PHOTOVOLTAICS: RESEARCH AND APPLICATIONS, JOHN WILEY & SONS, LTD, vol. 14, no. 2, 1 March 2006 (2006-03-01), pages 107-123, XP002577679, ISSN: 1062-7995, DOI: 10.1002/PIP.657 [retrieved on 2005-12-20]
- WANLASS M W ET AL: "Lattice-mismatched approaches for high-performance, III-V photovoltaic energy converters", CONFERENCE RECORD OF THE THIRTY-FIRST IEEE PHOTOVOLTAIC SPECIALIST CONFERENCE (IEEE CAT. NO. 05CH37608) IEEE PISCATAWAY, NJ, USA, IEEE, 3 January 2005 (2005-01-03), pages 530-535, XP010822764, DOI: 10.1109/PVSC.2005.1488186 ISBN: 978-0-7803-8707-2
- COOLEY W T ET AL: "PHOTOVOLTAIC ARRAY SPACE POWER FLIGHT EXPERIMENT PLUS DIAGNOSTICS (PASP+) MODULES", AEROSPACE POWER. SAN DIEGO, AUG 3 - 7, 1992; [PROCEEDINGS OF THE INTERSOCIETY ENERGY CONVERSION ENGINEERING CONFERENCE (IECEC)], NEW YORK, IEEE, US, vol. 1, 3 August 1992 (1992-08-03), pages 1.295-1.301, XP000366026, ISBN: 978-0-7803-0693-6
- YOO H ET AL: "Development of coplanar back contact for large area, thin, GaAs/Ge solar cells", PROCEEDINGS OF THE PHOTOVOLTAIC SPECIALISTS CONFERENCE. LAS VEGAS, OCT. 7 - 11, 19; [PROCEEDINGS OF THE PHOTOVOLTAIC SPECIALISTS CONFERENCE], NEW YORK, IEEE, US, vol. CONF. 22, 7 October 1991 (1991-10-07) , pages 1463-1468, XP010039150, DOI: 10.1109/PVSC.1991.169447 ISBN: 978-0-87942-636-1

## Description

### BACKGROUND OF THE INVENTION

### 1. Field of the Invention

The present invention relates to the field of solar cell semiconductor devices, and particularly to integrated semiconductor structures including a multijunction solar cell and a conducting via that allows both anode and cathode terminals to be placed on the back side of the cell.

### 2. Description of the Related Art

Photovoltaic cells, also called solar cells, are one of the most important new energy sources that have become available in the past several years. Considerable effort has gone into solar cell development. As a result, solar cells are currently being used in a number of commercial and consumer-oriented applications. While significant progress has been made in this area, the requirement for solar cells to meet the needs of more sophisticated applications has not kept pace with demand. Applications such as satellites used in data communications have dramatically increased the demand for solar cells with improved power and energy conversion characteristics.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as the payloads become more sophisticated, the design efficiency of solar cells, which act as the power conversion devices for the on-board power systems, become increasingly more important.

Solar cells are often fabricated in vertical, multijunction structures, and disposed in horizontal arrays, with the individual solar cell connected together in a series. The shape and structure of an array, as well as the number of cells it contains, are determined in part by the desired output voltage and current.

Inverted metamorphic solar cell structures such as described in U.S. Patent No. 6,951,819, the paper of M.W. Wanless et al., Lattice Mismatched Approaches for High Performance, III - V Photovoltaic Energy Converters (Conference Proceedings of the 31st IEEE Photovoltaic Specialists Conference, Jan. 3-7, 2005, IEEE Press, 2005), and U.S. Patent No. 8,536,445, present an important development in future commercial solar cell products.

Since a solar cell is fabricated as a vertical, multijunction structure, one electrical contact is usually placed on the top surface of the cell, and the other contact on the bottom of the cell, to avoid internal interconnections which may affect reliability and cost. A variety of designs are also known in which both contacts are placed on one side of the cell, including as represented in U.S. Patent Application 2006/0231130

Prior to the present invention, there has not been a inverted metamorphic solar cell with both anode and cathode contacts on the same side of the cell as claimed in claim 1.

### SUMMARY OF THE INVENTION

The present invention provides a multijunction solar cell having a front side surface and a back side surface including a first solar subcell adjacent the front side surface having a first band gap; a second solar subcell disposed over the first subcell and having a second band gap smaller than said first band gap; a grading interlayer disposed over the second subcell and having a third band gap greater than the second band gap; and a third solar subcell adjacent the back side surface and disposed over the interlayer, the third subcell being lattice mis-matched with respect to said second subcell and having a fourth band gap smaller than the third band gap. As claimed in claim 1 a via is formed in the first, second, and third solar cells with an electrical conductor extending through the via. An insulated contact pad is provided on the back side surface and electrically connected to the conductor to form a first terminal of the solar cell on the back side surface. A second terminal is formed on the back side surface by a metal layer making contact with a contact layer on the back side.

### BRIEF DESCRIPTION OF THE DRAWINGS

These and other features and advantages of this invention will be better and more fully appreciated by reference to the following detailed description when considered in conjunction with the accompanying drawings, wherein:
FIG. 1 is an enlarged cross-sectional view of a solar cell structure at the end of the process steps of forming a multijunction solar cell on a first substrate;
FIG. 2 is a cross-sectional view of the structure of FIG. 1 with a via etched to the first substrate;
FIG. 3 is a cross-sectional view of the solar cell structure of FIG. 2 after the next process step according to the present invention including depositing a dielectric layer and a conductive layer in the via;
FIG. 4 is a cross-sectional view of the solar cell of FIG. 3 after the next process step in which a wafer carrier or surrogate second substrate is adhered to the "top" side of the solar cell structure;
FIG. 5 is a cross-sectional view of the solar cell of FIG. 4 after the next process step in which the first substrate is removed;
FIG. 6 is a cross-sectional view of the solar cell of FIG. 5 after the next process step in which a cap layer and metal contact layer is deposited on the structure;
FIG. 7 is a cross-sectional view of the solar cell of FIG. 6 after the next process step in which a cover glass is adhered to the solar cell structure on one side, and the surrogate second substrate removed on the other side; and
FIG. 8A and 8B are top and bottom plan views, respectively, of a wafer including the solar cell of the present invention.

### DESCRIPTION OF THE PREFERRED EMBODIMENT

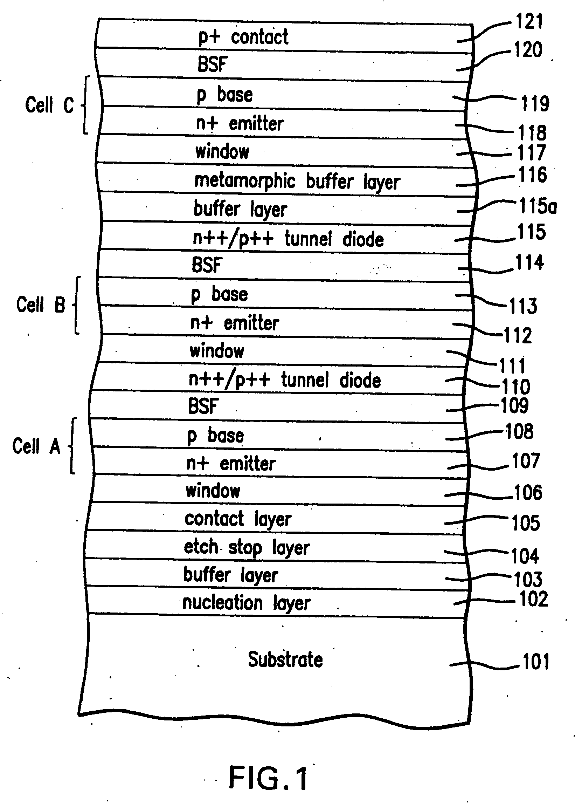

FIG. 1 depicts the multijunction solar cell after formation of the three subcells A, B and C on a substrate. More particularly, there is shown a first substrate 101, which may be either gallium arsenide (GaAs), germanium (Ge), or other suitable material. In the case of a Ge substrate, a nucleation layer 102 such as InGaP₂, is deposited on the substrate. On the substrate, or over the nucleation layer 102 in the case of a Ge substrate, a buffer layer 103 of InGaAs, and an etch stop layer 104 of InAlP₂ are further deposited. A contact layer 105 of InGaAs is then deposited on layer 104, and a window layer 106 of InAlP₂ is deposited on the contact layer. The subcell A, consisting of an n+ emitter layer 107 of InGaP₂ and a p-type base layer 108 of InGaP₂, is then deposited on the window layer 106.

Although the preferred embodiment utilizes the III - V semiconductor materials described above, the embodiment is only illustrative, and it should be noted that the multijunction solar cell structure could be formed by any suitable combination of group III to V elements listed in the periodic table subject to lattice constant and band gap requirements, wherein the group III includes boron (B), aluminum (Al), gallium (Ga), indium (In), and thallium (T). The group IV includes carbon (C), silicon (Si), germanium (Ge), and tin (Sn). The group V includes nitrogen (N), phosphorous (P), arsenic (As), antimony (Sb), and bismuth (Bi).

In the preferred embodiment, the substrate 101 is gallium arsenide, the emitter layer 107 is composed of InGa(Al)P₂, and the base layer is composed of InGa(Al)P₂. The use of parenthesis in the formula is standard nomenclature to indicate that the amount of aluminum may vary from 0 to 30%.

On top of the base layer 108 is deposited a p+ type back surface field ("BSF") layer 109 of InGaAlP which is used to reduce recombination loss.

The BSF layer 109 drives minority carriers from the region near the base/BSF interface surface to minimize the effect of recombination loss. In other words, a BSF layer 109 reduces recombination loss at the backside of the solar subcell A and thereby reduces the recombination in the base.

On top of the BSF layer 109 is deposited a sequence of heavily doped p-type (such as AlGaAs) and n-type layers 110 (such as InGaP₂) which forms a tunnel diode which is a circuit element to connect cell A to cell B.

On top of the tunnel diode layers 110 a window layer 111 of n++ InAlP₂ is deposited. The window layer 111 used in the subcell B also operates to reduce the recombination loss. The window layer 111 also improves the passivation of the cell surface of the underlying junctions. It should be apparent to one skilled in the art that additional layer(s) may be added or deleted in the cell structure without departing from the scope of the present invention.

On top of the window layer 111 the layers of cell B are deposited: the emitter layer 112, and the p-type base layer 113. These layers are preferably composed of InGaP₂ for the emitter and either GaAs or In_{0.015}GaAs for the base, respectively, although any other suitable materials consistent with lattice constant and band gap requirements may be used as well.

On top of the cell B is deposited a BSF layer 114 of p+ type AlGaAs which performs the same function as the BSF layer 109. A p++/n++ tunnel diode 115 is deposited over the BSF layer 114 similar to the layers 110, again forming a circuit element to connect cell B to cell C. A buffer layer 115a, preferably InGaAs, is deposited over the tunnel diode 115, with a thickness of about 1.0 micron. A metamorphic buffer layer 116 is then deposited over the buffer layer 115a. The layer 116 is preferably a compositionally step-graded composition of InGaAlAs deposited as a series of layers with monotonically changing lattice constant that provides a transition in lattice constant from cell B to subcell C. The bandgap of layer 116 is 1.5 ev constant with a value slightly greater than the bandgap of the middle cell B.

In one embodiment, as suggested in the Wanless et al. paper, the step grade contains nine compositionally graded steps with each step layer having a thickness of 0.25 micron. In the preferred embodiment, the interlayer is composed of InGaAlAs, with monotonically changing lattice constant.

On top of the metamorphic buffer layer 116 another n+ window layer 117 is deposited. The window layer 117 improves the passivation of the cell surface of the underlying junctions. Additional layers may be provided without departing from the scope of the present invention.

On top of the window layer 117 the layers of subcell C are deposited; the n-type emitter layer 118 and the p type base layer 119. In the preferred embodiment, the emitter layer is composed of GaInAs and the base layer is composed of GaInAs with about a 1.0 ev bandgap, although any other semiconductor materials with suitable lattice constant and band gap requirements may be used as well.

On top of the base layer 119 of subcell C a back surface field (BSF) layer 120, preferably composed of GaInAsP, is deposited.

Over or on top of the BSF layer 120 is deposited a p+ contact layer 121, preferably of p+ type InGaAs.

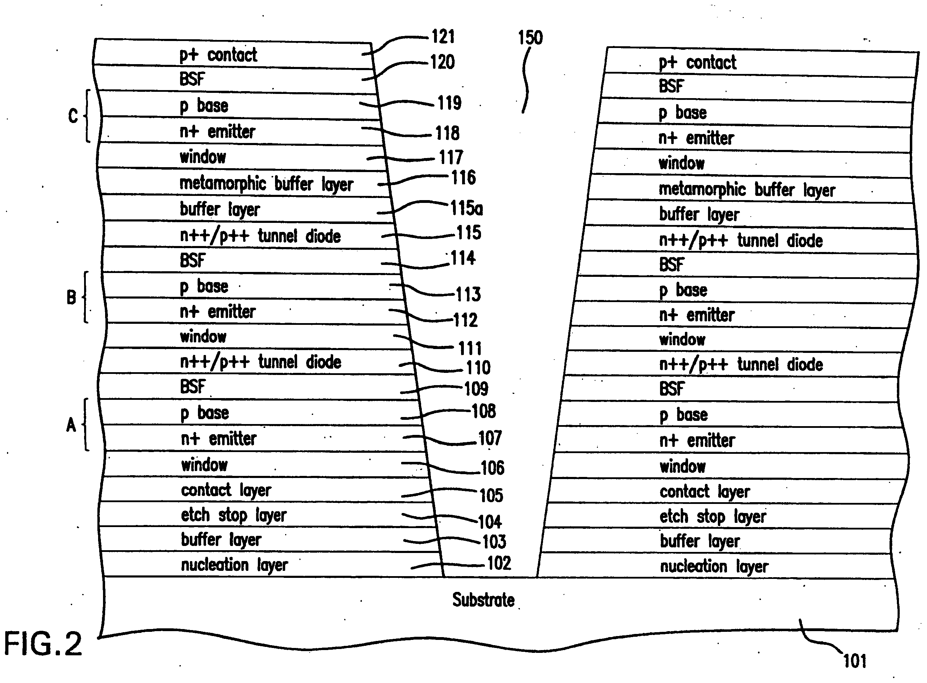

FIG. 2 is a cross-sectional view of the structure of FIG. 1 after the process step of a via 150 being etched from the top surface of the deposited layers 102 through 121 by dry or wet chemical processes to the substrate 101.

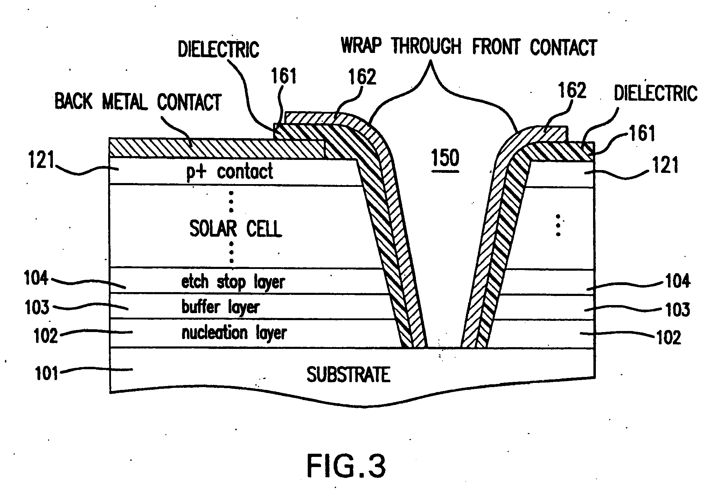

FIG. 3 is a cross-sectional view of the solar cell structure of FIG. 2 after the next sequence of process step according to the present invention including depositing a back metal layer over the p+ contact layer 121, and depositing a dielectric layer 161 in the interior of the via 150 and over a portion of the back metal contact layer. A conductive layer 162 is then deposited in the via 150 and over the dielectric layer 161. The layer 162 serves as a wrap through front contact for the solar cell.

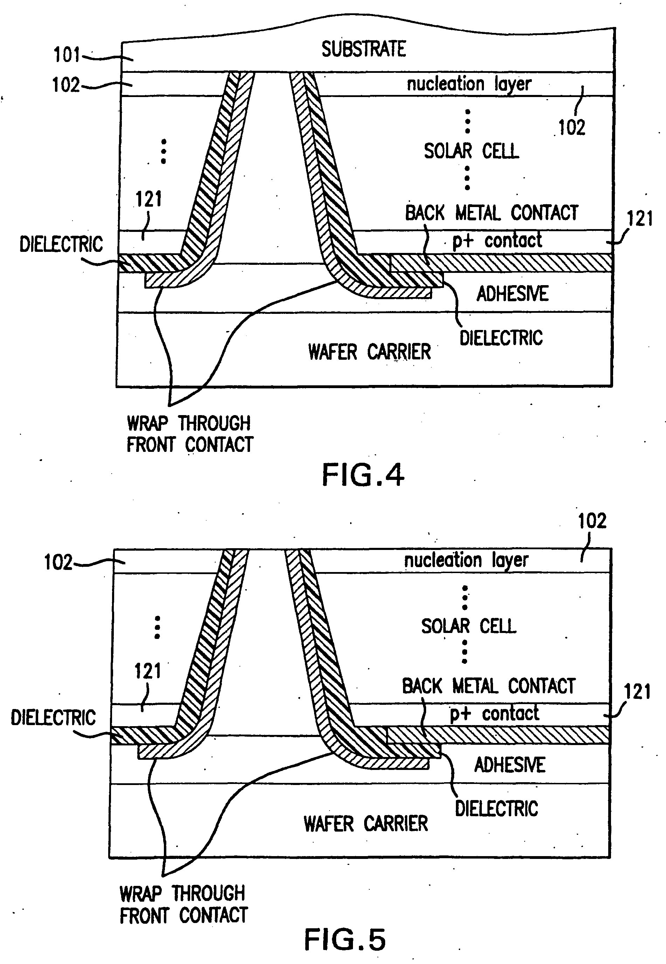

FIG. 4 is a cross-sectional view of the solar cell of FIG. 3 (how oriented with the substrate 101 at the top of the Figure) after the next process step according to the present invention. A wafer carrier or surrogate second substrate is adhered to the "top" side of the solar cell structure, which is now at the bottom of the Figure. In the preferred embodiment, the surrogate substrate is sapphire about 1000 microns in thickness, and is perforated with holes about 1 mm in diameter, spaced 4 mm apart, to aid in subsequent removal of the substrate.

FIG. 5 is a cross-sectional view of the solar cell of FIG. 4 after the next process step in which the first substrate 101 is removed by a lapping or grinding process.

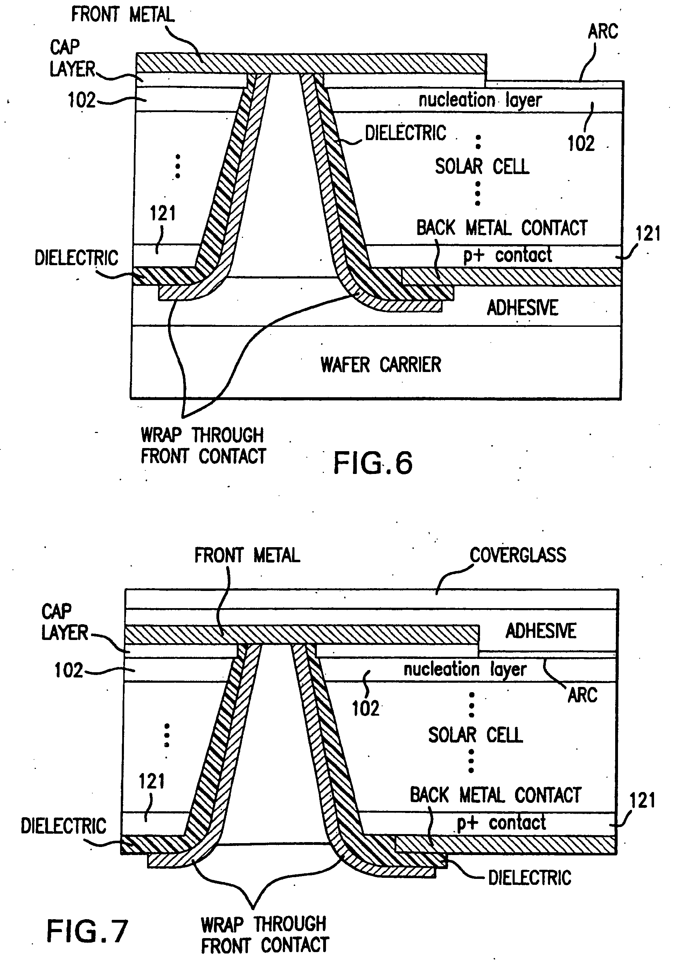

FIG. 6 is a cross-sectional view of the solar cell of FIG. 5 after the next process step according to the present invention in which a cap layer is deposited over a portion of the nucleation layer in the region of the via 150 and metal contact layer is deposited over the cap layer, making electrical contact with the metal layer 161 inside the via 150. An antireflective coating (ARC) layer is then applied over the surface of the nucleation layer.

FIG. 7 is a cross-sectional view of the solar cell of FIG. 6 after the next process step in which an adhesive is applied over the front metal layer and the ARC layer, and a cover glass is adhered to the solar cell structure. On the other side, the surrogate second substrate is then removed by dissolving the adhesive attaching it, or any other suitable technique.

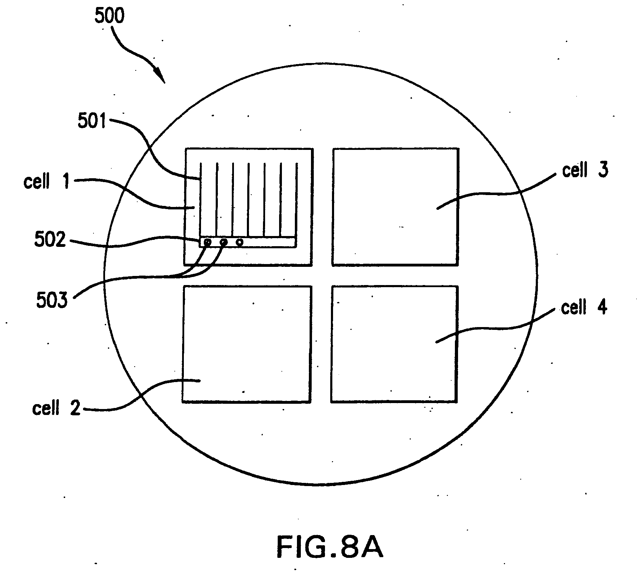

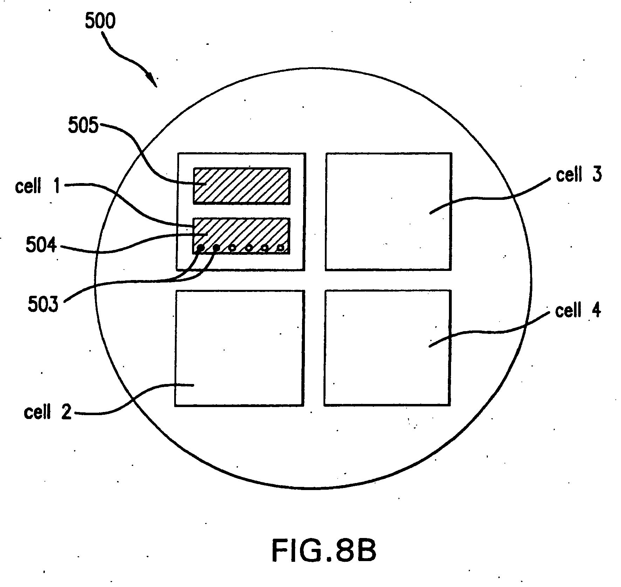

FIG. 8A and 8B are top and bottom plan views, respectively of a wafer including the solar cell of the present invention. In FIG. 8A, Cell 1 of each wafer is illustrated in greater detail with grid lines 501, a bus 502, and circular regions 503 in which a via 150 extends through the wafer such as shown in previous cross-sectional views.

FIG. 8B depicts the back side contact region 505 and a wrap through front contact region 504 with vias 503 corresponding to those shown in FIG. 8A.

## Claims

1. A multijunction solar cell having a front surface and a back surface, said solar cell comprising:
a sequence of layers (102-121) of semiconductor material that forms at least two cells of a multijunction solar cell, including:
a via (150) extending from the top surface (Fig. 8a) of said sequence of layers (102-121) to the back surface (Fig. 8b);
a back metal contact layer over the last layer (121) of the sequence of layers;
a layer of dielectric material (161) circumferentially around the inside surface of the via (150) and over a portion of the back metal contact layer;
a conductive layer (162) over said layer of dielectric material (161) extending throughout the via (150) and over a portion of the layer of dielectric material (161);
a front metal grid (501) on the front surface of the solar cell electrically connected to said conductive layer (162).

2. The solar cell of claim 1, wherein the back contact metal layer comprises a bal side contact region (505), and the conductive layer (162) comprises a wrap through front contact region (504).

3. The solar cell of claim 1, wherein said sequence of layers of semiconductor material comprises a first solar subcell (cell A) having a first band gap; a second solar subcell (cell B) over said first subcell having a second band gap smaller than said first band gap; a grading interlayer (114) over said second subcell having a third band gap larger than said second band gap; a third solar subcell (cell C) having a fourth band gap smaller than said second band gap such that said third subcell is lattice mis-matched with respect to said second subcell.

4. The solar cell as defined in claim 3, wherein said first solar subcell (cell A) is composed of an InGa(Al)P emitter region and an InGa(Al)P base region, and said second solar subcell (cell B) is composed of an InGaP₂ emitter region and an In_{0.015}GaAs base region.

5. The solar cell as defined in claim 3, wherein the grading interlayer (113) is composed of a plurality of layers of InGaAlAs with monotonically increasing lattice constant.

## Patentansprüche

1. Mehrfachsolarzelle mit einer vorderen Oberfläche und einer hinteren Oberfläche, wobei die Solarzelle umfasst:
eine Abfolge von Schichten (102-121) aus Halbleitermaterial, die mindestens zwei Zellen einer Mehrfachsolarzelle bilden, einschließlich:
eine Lücke (150), die sich von der oberen Oberfläche (Fig. 8a) der Abfolge von Schichten (102-121) zu der hinteren Oberfläche (Fig. 8b) erstreckt;
eine Rückmetallkontaktschicht auf der letzten Schicht (121) der Abfolge von Schichten;
eine Schicht aus dielektrischem Material (161), die in Umfangsrichtung um die innere Oberfläche der Lücke (150) herum und über einem Abschnitt der Rückmetallkontaktschicht ist;
eine leitfähige Schicht (162) über der Schicht aus dielektrischem Material (161), die sich durch die Lücke (150) und über einen Abschnitt der Schicht aus dielektrischem Material (161) erstreckt;
ein vorderes Metallgitter (501) auf der vorderen Oberfläche der Solarzelle, die elektrisch mit der leitenden Schicht (162) verbunden ist.

2. Solarzelle nach Anspruch 1, wobei die Rückkontaktmetallschicht eine Rückseitenkontaktregion (505) umfasst und die leitfähige Schicht (162) eine Wrap-Through-Frontseitenkontaktregion (504) umfasst.

3. Solarzelle nach Anspruch 1, wobei die Abfolge von Schichten aus Halbleitermaterial eine erste Solar-Subzelle (Zelle A) mit einer ersten Bandlücke; eine zweite Solar-Subzelle (Zelle B) über der ersten Subzelle mit einer zweiten Bandlücke, die kleiner als die erste Bandlücke ist; eine Abstufungszwischenschicht (114) über der zweiten Subzelle mit einer dritten Bandlücke umfasst, die größer ist als die zweite Bandlücke; eine dritte Solar-Subzelle (Zelle C) mit einer vierten Bandlücke, die kleiner ist als die zweite Bandlücke, so dass die dritte Subzelle bezüglich der zweiten Subzelle gitterfehlangepasst ist.

4. Solarzelle nach Anspruch 3, wobei die erste Solar-Subzelle (Zelle A) aus einer InGa(Al)P-Emitterregion und einer InGa(Al)P-Basisregion zusammengesetzt ist und die zweite Solar-Subzelle (Zelle B) aus einer InGaP₂-Emitterregion und einer In_{0,015}-GaAs-Basisregion zusammengesetzt ist.

5. Solarzelle nach Anspruch 3, wobei die Abstufungszwischenschicht (113) aus einer Mehrzahl von Schichten aus InGaAlAs mit monoton zunehmender Gitterkonstante zusammengesetzt ist.

## Revendications

1. Une cellule solaire multijonction ayant une surface avant et une surface arrière, ladite cellule solaire comprenant:
une séquence de couches (102-121) de matériau semi-conducteur qui forme au moins deux cellules d'une cellule solaire multijonction, y compris :
un via (150) s'étendant de la surface supérieure (Fig. 8a) de ladite séquence de couches (102-121) à la surface arrière (Fig. 8b);
une couche de contact métallique arrière sur la dernière couche (121) de la séquence de couches;
une couche de matériau diélectrique (161) circonférentiellement autour de la surface intérieure du via (150) et sur une portion de la couche de contact métallique arrière;
une couche conductrice (162) sur ladite couche de matériau diélectrique (161) s'étendant à travers du via (150) et sur une portion de la couche de matériau diélectrique (161);
une grille métallique avant (501) sur la surface avant de la cellule solaire connectée électriquement à ladite couche conductrice (162).

2. La cellule solaire selon la revendication 1, dans laquelle la couche de contact métallique arrière comprend une région de contact de face arrière (505) et la couche conductrice (162) comprend une région de contact de wrap-through avant (504).

3. La cellule solaire selon la revendication 1, dans laquelle ladite séquence de couches de matériau semi-conducteur comprend une première sous-cellule solaire (cellule A) ayant une première bande interdite; une seconde sous-cellule solaire (cellule B) sur ladite première sous-cellule ayant une seconde bande interdite inférieure à ladite première bande interdite; une couche intermédiaire de classement (114) sur ladite seconde sous-cellule ayant une troisième bande interdite plus grande que ladite seconde bande interdite; une troisième sous-cellule solaire (cellule C) ayant une quatrième bande interdite inférieure à ladite seconde bande interdite de telle sorte que ladite troisième sous-cellule a un réseau différent par rapport à ladite seconde sous-cellule.

4. La cellule solaire selon la revendication 3, dans laquelle ladite première cellule solaire (cellule A) est composée d'une région d'émetteur d'InGa(Al)P et d'une région de base d'InGa(Al)P et ladite seconde cellule solaire (cellule B) est composée d'une région d'émetteur d'InGaP₂ et d'une région de base d'In_{0,015}GaAs.

5. La cellule solaire selon la revendication 3, dans laquelle la couche intermédiaire de classement (113) est composée d'une pluralité de couches d'InGaAlAs ayant une constante de réseau à augmentation monotone.
